# FASCICULE DE BREVET EUROPEEN

(11) **EP 1 058 898 B1**
(45) Date de publication et mention de la délivrance du brevet: **30.07.2003**
(21) Numéro de dépôt: 99907659.9
(22) Date de dépôt: 04.03.1999
(51) Int. Cl.: G06F 17/50

(54) **OUTIL INFORMATIQUE POUR L'ETUDE D'ARCHITECTURES ELECTRIQUES DESTINEES A ETRE DISPOSEES A L'INTERIEUR D'UN VEHICULE AUTOMOBILE**
COMPUTERWEKZEUG ZUM UNTERSUCHEN VON ELEKTRISCHEN INSTALLATIONSARCHITEKTUREN FÜR DIE ANORDNUNG INNERHALB EINES KRAFTFAHRZEUGES
COMPUTER-BASED TOOL FOR STUDYING ELECTRICAL ARCHITECTURES DESIGNED TO BE INSTALLED INSIDE A MOTOR VEHICLE

(30) Priorité: 04.03.1998 FR 9802611
(43) Date de publication de la demande: 13.12.2000
(73) Titulaire: VALEO ELECTRONIQUE, 94000 Creteil (FR)
(72) Inventeur: BOUCHERON, Jean-Louis, F-77176 Savigny-le-Temple (FR)
(74) Mandataire: Le Forestier, Eric
(86) Numéro de dépôt international: FR9900490
(87) Numéro de publication internationale: WO99045485

(56) Documents cités:
- EP-A- 0 424 189
- WO-A-93/01557
- WO-A-94/23372
- US-A- 5 038 294

## Description

La présente invention est relative à un outil pour l'étude d'architectures électriques à l'intérieur d'un véhicule automobile.

L'invention permet en particulier de capitaliser des informations relatives aux différents éléments susceptibles d'être utilisés dans les architectures électriques des véhicules ainsi que de capitaliser les fonctions susceptibles d'être réalisées à partir de ces éléments, ainsi que les différents modules ou calculateurs permettant de commander et de réaliser ces fonctions et les architectures électriques réalisées avec ces modules ou calculateurs et ces fonctions.

L'outil proposé par l'invention permet en outre de mettre en oeuvre sur les fonctions ou les modules ou calculateurs un traitement de consolidation destiné à permettre d'éviter les redondances entre les différents éléments intervenant dans les fonctions et/ou utilisés par les calculateurs.

Egalement, l'outil proposé permet à un opérateur d'avoir accès rapidement aux coûts de câblage et d'électronique mis en oeuvre à partir de différentes solutions d'architecture, en vue de l'expertise de celles-ci.

On notera qu'à ce jour, ce type d'études exhaustives n'est pratiquement jamais mis en oeuvre car beaucoup trop fastidieux.

On connaît déjà par la demande de brevet WO 94 23 372 un moyen pour configurer un système construit à partir de divers composants et en particulier un système composé de cartes électroniques utilisant des composants optionnels dont le système doit reconnaître la présence ou non.

Le système dont il s'agit est par exemple un ordinateur dans lequel une carte mère accueille différentes cartes optionnelles. A la mise sous tension, un programme d'initialisation reconnaît les périphériques connectés et sait reconfigurer le programme pour prendre en compte les cartes optionnelles ou les différents équipements possibles.

Pour cela, la méthode proposée s'intéresse à une définition système basée sur une définition « hardware » complète (connecteurs, circuits internes, microcontroleurs, mémoires ROM, RAM, et ressources spécifiques des microcontroleurs, etc.). Cette définition très précise est limitée au seul calculateur considéré et ses périphériques intégrés.

Un but de l'invention est de proposer un outil informatique particulièrement adapté à l'étude d'architectures électriques à l'intérieur de véhicules automobiles et permettant de fournir à un opérateur une architecture optimisée.

L'invention propose un outil informatique pour l'étude d'architectures électriques destinées à être disposées à l'intérieur d'un véhicule automobile comportant :
- des moyens de mémorisation dans lesquels sont stockés des fichiers de données primaires décrivant des éléments électriques ou électroniques,
- des moyens pour mettre à jour ces données primaires,
- des moyens pour permettre à un opérateur de créer à partir de ces données primaires des fonctions définies chacune notamment par une liste d'éléments du type de ceux décrits dans les fichiers de données primaires, ainsi que par la description de toutes les liaisons entre ces divers éléments,
- des moyens de mémorisation dans lesquels sont stockées les fonctions ainsi créées, caractérisé en ce que, pour l'étude de l'architecture électrique d'un véhicule automobile, les données primaires décrivent des éléments électriques ou électroniques parmi lesquels des organes de commande et des capteurs de véhicules automobiles, des entrées et sorties électroniques de calculateur, des entrées et sorties de puissance de calculateur, des schémas électroniques de type couches basses associées à ces entrées et sorties électroniques du calculateur, des composants de puissance, des composants électroniques,
et en ce qu'il comporte des moyens pour permettre à un opérateur de sélectionner plusieurs ensembles de fichiers et pour de façon automatique :
- générer pour chaque ensemble de fonctions choisi, une liste dite consolidée des éléments correspondant à ces différentes fonctions, dans laquelle les redondances entre éléments sont supprimées,
- définir pour chacune de ces listes consolidées un calculateur apte à gérer les différentes fonctions de celles-ci et générer une liste de liaisons dite consolidée décrivant les liaisons nécessaires pour la mise en oeuvre des différentes fonctions choisies, dans laquelle les redondances entre liaisons sont supprimées,
- regrouper ces calculateurs en les associant à des architectures de faisceaux de liaison mémorisés, afin de définir des systèmes,
- calculer les coûts des calculateurs ainsi regroupés et/ou de leurs fonctions, afin de permettre à l'opérateur de sélectionner un système correspondant pour lui à une solution optimale.

Ainsi, on dispose d'un outil qui permet de constituer une base de données qui permet de créer et de recenser des fonctions électroniques possibles à l'intérieur d'un véhicule, ainsi que des modules de calculateurs (et architectures) associés à ces fonctions, qui mettent en relation - par l'intermédiaire d'un câblage à l'intérieur du véhicule - les organes de commande, des capteurs et des organes commandés (moteurs, lampes, actionneurs, etc...).

Un tel outil est avantageusement complété par les différentes caractéristiques suivantes prises seules ou selon toutes leurs combinaisons possibles :
- il comporte des moyens de mémorisation dans lesquels sont stockées les schémas des architectures de faisceaux de différents types de véhicule ;
- il comporte des moyens pour proposer une segmentation optimisée à partir d'une architecture de faisceau donnée et d'un fichier de modules ou calculateurs consolidés ;
- il comporte des moyens permettant à un opérateur de modifier les schémas électriques appelés couches basses associées à un module de calculateur pour optimiser ledit module ;
- il comporte des moyens mémoire dans lesquels sont stockées des spécifications et/ou des schémas et/ou des nomenclatures associés aux éléments décrits dans les fichiers de données primaires ;
- il comporte des moyens de mémorisation dans lesquels sont stockées des spécifications et/ou des schémas et/ou des fiches signalétiques associés aux fonctions ;
- il comporte des moyens pour regrouper les informations contenues dans des fiches signalétiques associées à des fonctions dans un fichier associé au module de calculateur regroupant ces fonctions ;
- il comporte des moyens pour mémoriser et/ou traiter de façon différenciée les fonctions selon qu'elles sont destinées à être intégrées à des architectures conventionnelles, destinées à être consolidées à un seul module de calculateur ou destinées à être consolidées en plusieurs modules.

Un tel outil présente de nombreux avantages, et notamment :
- il permet la capitalisation technique des fonctions et des architectures associées par fonction, schémas, besoins en entrées et sorties, organes associés, circuits et composants de puissance nécessaires, spécifications, etc...
- il permet des expertises rapides de différentes solutions d'architectures.
- il permet de prendre en compte le coût global d'une architecture (y compris le coût de son câblage) et non le coût de l'électronique seule.
- il permet de capitaliser différentes architectures de faisceaux, etc.

La description qui suit est purement illustrative et non limitative. Elle doit être lue en regard de la figure unique annexée qui est un organigramme sur lequel on a représenté les différentes couches de données utilisées par un outil conforme à un mode de réalisation particulier possible pour l'invention.

Le traitement qui va maintenant être décrit est mis en oeuvre par un logiciel qui se compose :
- D'un module "banque de données primaires" 1 qui comprend entre autres une base de données qui recense des composants électroniques et leurs coûts. Ce module intègre une procédure de mise à jour, et des possibilités de consultation.
- D'un module de création et de gestion d'une banque de donnée "Fonctions ", qui intègre une procédure de création des fonctions faisant appel à la "banque de données primaires". Ce module intègre également une procédure de mise à jour, et des possibilités de consultation.
- D'un module de création et de gestion d'une banque de données "modules ou calculateurs consolidés ", qui intègre une procédure de création et de gestion des calculateurs faisant appel à la "banque de données Calculateurs " et met en oeuvre une "procédure de consolidation de fonctions". Ce module intègre également une procédure de mise à jour, et des possibilités de modification et de consultation.
- D'un module de capitalisation des architectures de référence, faisant appel à une banque de données "Architectures faisceaux ". Ce module intègre également une procédure de mise à jour, et des possibilités de consultation.
- D'une procédure "d'optimisation d'un calculateur " permettant la transformation d'un fichier "Calculateur consolidé " en un fichier "Calculateur optimisé" prenant en compte les choix effectués en terme de circuits électroniques représentatifs des "couches basses".
- D'un module de " Segmentation " permettant de transposer les données contenues dans le fichier "Architectures" sur un ou plusieurs calculateurs ou modules pour en décomposer les liaisons par faisceau en vue de l'évaluation des coûts de câblage associés à un système défini par ces calculateurs ou modules.

Après optimisation il est possible de permettre une série de corrections manuelles qui seront prises en compte dans le processus d'évaluation. Comme les autres modules celui-ci intègre une procédure de mise à jour, et des possibilités de modification et de consultation.

### 1 - LA BASE DE DONNEES PRIMAIRES

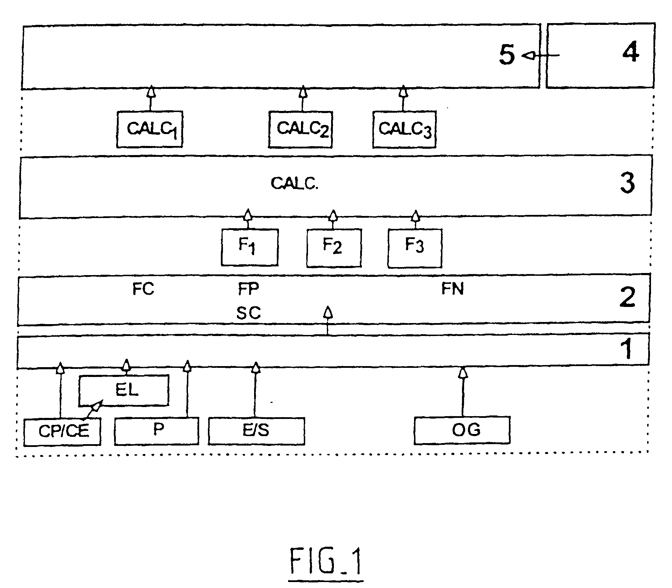

Ainsi qu'on peut le voir sur la figure 1, la base de données primaires 1 comporte :
- un fichier organes (OG).
- un fichier entrées et sorties électroniques du calculateur consolidé (E/S).
- un fichier entrées et sorties de puissance du calculateur consolidé (P)
- un fichier liste des schémas électroniques couches basses associees aux entrées et sorties électroniques du calculateur (EL).
- un fichier liste des composants de puissance (CP) et de composants électroniques (CE).

### 1.1 - Le fichier organes (OG) :

Ce fichier définit tous les organes susceptibles d'occuper une position fixe sur un véhicule donné, ce qui permettra via les localisations de ces organes et les liaisons électriques nécessaires entre ces organes de définir dans une première étape les composantes de ces liaisons transférées sur un faisceau véhicule en nombre de fils, interconnexions, et points de connexions, ceci en vue d'une évaluation rapide des coûts du câblage associé à une fonction pour une architecture faisceau donnée.

Ce fichier organe permet de capitaliser, par l'intermédiaire d'un schéma S représentatif codifié et éventuellement d'une spécification sommaire associée des organes (limitée aux points pertinents), différentes configurations ou catégories d'organes disponibles.

Par exemple, ce fichier recense des familles de composants proches, par exemple :
- Boîtes à fusibles, platines de servitude
- Boîtiers électroniques conventionnels
- Commutateurs et dispositifs de commande
- Capteurs

Egalement, il peut recenser des composants distincts appartenant à une même fonction
- Moteur d'essuie-vitre, pompe de lavage, capteur de niveau d'eau.

### 1.2 - Le fichier liste des entrées et sorties de la carte électronique

Ce fichier est destiné à définir une liste unique des entrées et sorties de la carte électronique qui intégrera un calculateur commun à la gestion de plusieurs fonctions. Les entrées et sorties de ce calculateur commun sont déterminées en éliminant les entrées ou sorties redondantes

Ces entrées et sorties ont une signification physique et permettent de se relier d'un côté aux schémas électroniques par la définition des couches basses du calculateur et de l'autre au câblage extérieur vers les organes associés.

Ce fichier recense notamment des entrées et sorties regroupées par famille proches des fonctions par exemple
- Alimentations et signaux d'alimentation.
- Entrées et sorties relatives au contrôle de l'ouverture des portes et des ouvrants.
- Entrées et sorties relatives à la commande des indicateurs de direction et au warning.
etc...

### 1.3 - Fichier des entrées et sorties de la partie de puissance :

Ce fichier est destiné à définir une liste unique des entrées et sorties de la partie contrôlant la partie puissance afin que lors de l'opération de consolidation des fonctions, les entrées ou sorties de puissances redondantes soient éliminées. Ces entrées et sorties ont une signification physique et permettent de se relier aux schémas électriques internes de la partie puissance (ce qui permet d'associer les composants de puissance nécessaires ex : fusibles, relais, shunts, etc...) et au câblage extérieur vers les organes connectés.

Le schéma S représentatif de la fonction permet de faire le lien entre la partie puissance du calculateur et ses liaisons avec les organes externes d'une part (par le schéma externe), avec les composants de puissance (équipement interne), et avec les liaisons nécessaires entre la partie électronique et la partie puissance définissant également un premier niveau du schéma S électronique pour gérer la liaison (couche basse nécessaire à la gestion de la panie puissance ).

Ce fichier recense notamment des entrées et sorties regroupées par famille proches des fonctions, par exemple :
- Alimentations et signaux d'alimentation.
- Entrées et sorties relatives au contrôle de l'ouverture des portes et des ouvrants.
- Entrées et sorties relatives à la commande des indicateurs de direction et au warning

### 1.4 - Fichier liste des schemas électroniques "couches basses" associées aux entrées/sorties du calculateur a consolider :

Ce fichier est destiné à définir une liste unique des besoins relatifs aux entrées et sorties de la carte électronique. Ces besoins correspondent à des parties de schémas qui, dans la suite du texte, seront appelés : couches basses hardware du calculateur.

Ces schémas couches basses sont en relation directe avec ce que nous appellerons le calculateur (circuit logique câblé, ASIC ou microcontrôleur) qui pilotera les fonctions demandées à travers ces couches basses.

De fait, la globalisation du besoin exprimé en couches basses permet de définir le besoin en coeur numérique. Ex : Entrées et sorties numériques, entrées analogiques, sorties PWM, liaisons séries, etc...

A chaque besoin en couche basse doit correspondre un ou plusieurs schémas possibles qui pourront être utilisés dans la carte électronique. Ceci permettra à terme de standardiser les circuits et de choisir des schémas vérifiés, compétitifs, et validés dans l'environnement automobile.

A chaque schéma correspondant à un besoin en couche basse sera associé une nomenclature, ce qui permettra (lors de la consolidation des fonctions) de connaître la liste des composants nécessaires à la réalisation de la globalité des circuits couches basses d'un projet.

Le besoin en couches basses permet de définir rapidement le besoin autour du coeur numérique après consolidation des fonctions retenues.

L'utilisation du "fichier couches basses" et des fichiers schémas et nomenclatures associées se fait.
Lors de l'opération de création d'une fonction
Lors de l'opération de consolidation des fonctions ce qui permet d'obtenir.
- une liste complète des schemas de base utilisés, et le nombre de fois que ceux-ci sont utilisés.
- Une nomenclature consolidee de tous les composants nécessaires utilisant lesdits schémas
- Le besoin en entrées et sorties requises avec les schémas utilisés pour se raccorder au coeur numérique.
- Le coût global des composants utilisés.
Lors de l'opération d'optimisation ce qui permet :
- De modifier un fichier consolidé pour choisir des schémas de couche basse de variante N° "n", ou de remplacer une référence de couche basse par une référence de schéma de type ASIC compatible et d'obtenir après optimisation les données identiques à celles précédemment fournies, mais réactualisées.

La consolidation des besoins en coeur numérique (qui peut être menée à la fin de l'opération de consolidation ou de l'opération d'optimisation) totalise la demande en couches basses pour un calculateur en recherchant la liste des codes numériques différents et mémorise pour chacun d'eux les quantités trouvées correspondantes.

### 1.5 - Fichier liste des composants de puissance CP et des composants électroniques CE

Ce fichier a pour objectif de définir une liste unique des composants électronique et de puissance qui peuvent être utilisés pour composer les couches basses ou pour équiper la partie puissance du calculateur à consolider.

A chaque type de composant est associé (via la base de donnée existante) un fichier de spécification SC qui pourra être consulté ou édité.

La consolidation des fonctions doit permettre de disposer rapidement de la liste des composants nécessaires pour realiser une application.

A chaque type de composant on associera un coût, qui permettra d'approcher rapidement les coûts de la partie puissance et des circuits couches basses.

Ces données relatives au coût peuvent être réactualisées via la banque de donnée existante.

La création et mise à jour se fait par un numéro de composant en respectant une codification, ces numéros seront organisés en utilisant des champs par ramille pour plus de facilité

Ces numéros de composants se retrouvent dans la fiche signalétique de la fonction lorsque celle-ci décrit une partie puissance associée à une fonction.

Après consolidation d'un ensemble de fonctions, le programme permet d'obtenir une liste complète des composants utilisés avec leurs coûts associés.

Les composants sont regroupés dans ce fichier par familles, telles que :
- Relais
- Fusibles
- Shunts
- Transistors
- Résistances.
etc...

### 2 - CONSTITUTION DE LA BASE DE DONNEES DES FONCTIONS

Ainsi que l'illustre la figure 1, la procédure de création de fonctions nécessite de puiser dans la base de données primaires 1 qui vient d'être décrite.

La capitalisation des fonctions se fait :
- suivant le type de fonction :
   - Les fonctions de type FC (fonctions en architecture conventionnelle)
   - Les fonctions de type FN (fonction nominale décrite pour être consolidée en un seul calculateur)
   - Les fonctions de type FP (fonction partagée décrite pour être consolidée en plusieurs modules)
et dans la base de donnée des fonctions

Chaque fonction est en particulier définie par une liste d'organes, une liste d'entrée et sortie électroniques, une liste d'entrée et sortie de puissance, une liste de schémas électroniques couches basses, ainsi qu'une liste de composants de puissance et de composants électroniques et une liste des liaisons électriques du schéma associé.

Les fonctions sont stockées dans une base de données 2 prévue à cet effet et sont crees et mises à jour en utilisant la bibliothèque de la base de données primaire 1.

A chaque fonction FC (fonction de type conventionnel) sont associés un "schéma fonction", une "fiche signalétique fonction " et "une spécification SC fonction ". Ces fonctions regroupent des architectures de type conventionnel pour lesquelles il n'y aura pas de consolidation de calculateur, la fonction étant généralement prise en compte par un boîtier séparé considéré comme un organe.

L'opération de consolidation sur des fonctions de type FC conduira à consolider tous les organes utilisés (y compris les boîtiers conventionnels ), et consolider le câblage nécessaire à la prise en compte de l'ensemble de ces fonctions.

Les architectures obtenues après consolidation des fonctions FC sont avantageusement utilisées comme références auxquelles on compare les autres architectures.

A chaque fonction FN (fonction Nominale définie pour être consolidable en un seul calculateur ) sont associés un "schéma fonction", une "fiche signalétique fonction" et "une spécification SC fonction".

Cette définition en trois parties permet de documenter totalement un besoin étude relatif à la définition d'une fonction de manière telle que l'opération de consolidation de n fonctions puisse conduire à définir rapidement un calculateur consolidé et le câblage associé nécessaire à la prise en compte de l'ensemble de ces fonctions dans une architecture globale.

A chaque fonction FP (fonction Partagée, définie comme pouvant être assurée en globalisant le travail de plusieurs calculateurs, modules, ou encore stations pour cette fonction ) sont associées "un schéma fonction en plusieurs parties", une " fiche signalétique fonction en plusieurs parties " et " une seule spécification SC fonction ".

Cette définition permet de consolider en plusieurs calculateurs ou modules un ensemble de fonctions Chaque calculateur ou module doit au préalable être consolidé séparement. Une opération de consolidation étude système permettra de connaitre sur une conception globale d'un système, l'ensemble des besoins en eiectronique et composants de puissance, et le câblage associé nécessaire à la prise en compte de l'ensemble des fonctions prises en compte par l'ensemble des connexions nécessaires à tous ces modules

### 3 - LA PROCEDURE DE CONSOLIDATION DES FONCTIONS ET LA CAPITALISATION DES CALCULATEURS

L'objectif de l'outil développé étant l'évaluation rapide des architectures possibles pour un ensemble de fonctions donné, pour chacune des architectures à évaluer, il convient de mesurer les poids respectifs du (ou des) calculateurs impliqués dans le système, et ceux du ou des câblages nécessaires à la réalisation de l'architecture proposée.

La première phase de cette étude conduit à construire (un ou plusieurs calculateurs ) autour d'un ensemble de fonctions déterminées (F₁, F₂, F₃ sur la figure). Cette construction est réalisée par sélection d'un ensemble de fonctions dans la base de données 2 et par une opération dite de consolidation de ces fonctions au sein d'un même ou de plusieurs calculateurs.

L'ensemble de ces calculateurs consolidés (CALC. sur la figure) et leurs attributs respectifs constituent des études qui pourront être archivées et qui constitueront une base de données calculateurs 3.

Lors de l'étape de sélection, les fonctions sont rassemblées sous un "Numéro de calculateur ".

L'opération de consolidation permet au logiciel de regrouper l'ensemble des informations contenues dans les fichiers "fiches signalétiques associées aux fonctions" sélectionnées dans un fichier unique appelé "Fichier étude calculateur (ou module) consolidé".

A l'issue de l'opération de consolidation, le "Fichier calculateur consolidé" contient :
- Le Numéro d'étude.
- Le numéro de calculateur et son appellation
- La liste des fonctions sources prises en compte dans l'opération de consolidation
- La liste de tous les organes mis en jeu pour l'ensemble des fonctions prises en compte, (liste dans laquelle les donnees redondantes sont eliminées et chaque organe n'est cité qu'une fois)
- La liste des entrées et sorties à la partie électronique, (dans laquelle les données redondantes sont éliminées et chaque entrée ou sortie n'est citée qu'une fois).
- La liste des entrées et sorties à la partie puissance, (dans laquelle les données redondantes sont éliminées et chaque entrée ou sortie n'est citée qu'une fois).
- La liste du besoin en électroniques (dans laquelle les données redondantes sont éliminées).

Cette liste donne les couches basses nécessaires pour connecter les entrées et sorties au calculateur d'habitacle, mais également la liste des couches basses relatives aux circuits nécessaires pour la liaison entre la partie électronique et la partie puissance.
- La liste complète des liaisons électriques entre les organes pris en compte dans les fonctions retenues.

Cette liste contient les liaisons entre le calculateur et les organes reliés aux entrées et sorties de la partie électronique comme de la partie puissance, mais aussi les liaisons entre organes et organes et masses ou alimentations directes.

Cette liste doit permettre de décrire les liaisons nécessaires pour qu'un schéma soit susceptible de fonctionner.

Cette liste élimine également les liaisons redondantes lors de l'opération de consolidation.
- La liste des entrées et sorties nécessaires entre la partie électronique et la partie puissance
- La nomenclature complète des composants de puissance décrits dans l'ensemble des fonctions consolidées.
- La liste du besoin en coeur numérique.

### 4 - LA CAPITALISATION DES ARCHITECTURES FAISCEAUX

Pour un même schéma de principe, l'architecture faisceau choisie par le constructeur conduira à un nombre de fils différents. En effet le nombre de fils nécessaires dépendra du schéma de principe utilisé, mais aussi de la segmentation du faisceau choisie (Par segmentation, on entend un découpage d'une liaison électrique utilisée entre un point et un autre et qui emprunte un parcours passant à travers plus d'un faisceau, les différents faisceaux étant reliés entre eux par des dispositifs de raccordement).

A cet effet, les architectures faisceaux sont capitalisées par véhicule et par constructeur dans une banque de données 4
- à partir de la définition des faisceaux renseignée sur " la fiche signalétique liée à une architecture faisceau", le logiciel permettra de décomposer chaque fil du schéma de principe des fonctions retenues en autant de tronçons que rendues nécessaires par l'architecture faisceau retenue, lors de l'opération de segmentation/consolidation.

Ces données extraites d'une architecture faisceau connue et associée à un véhicule vont permettre de constituer une base de données qui doit permettre d'automatiser l'évaluation des coûts des faisceaux associés à une ou plusieurs solutions.

Les données relatives à la capitalisation des architectures faisceaux sont acquises sous la forme de deux documents
- Un " schéma représentatif de l'architecture faisceaux" utilisée.
- Un fichier constituant " la fiche signalétique liée à une architecture faisceau".

### 5- LA PROCEDURE DE CONSOLIDATION DES SYSTEMES ET ARCHITECTURES

Les modules de calculateurs recenses dans le fichier 3 peuvent être regroupés pour constituer des systèmes en les associant à des architectures faisceaux (la figure illustre un exemple de regroupement de trois calculateurs CALC₁, CALC₂, CALC₃)

L'opération de "consolidation système " permet d'obtenir rapidement les données relatives à la définition d'un système complet permettant ainsi de disposer des données qui permettront la comparaison de différentes architectures. A ce titre on pourra comparer plusieurs solutions mettant en jeu des choix d'architecture différents.

Les architectures associés aux systèmes ainsi consolidés sont capitalisés dans une base de données 5.

### 6- OPTIMISATION DES CALCULATEURS

La phase d'optimisation intervient après la phase de consolidation et permet de transformer un fichier étude calculateur "ou module" consolidé en un fichier étude optimisée.

L'optimisation consiste à intervenir sur les champs relatifs à la définition des circuits "couches basses" pour optimiser le calculateur.

Lors de l'opération d'optimisation il doit être possible de consulter les résultats de la consolidation pour juger du résultat obtenu après modification des variantes des circuits "couches basses".

Cette consultation concerne :
- Le résultat de l'opération de consolidation des "circuits couches basses" en terme de :
   - Coût global composants électroniques
   - Nombre total de composants.
   - Le besoin global en coeur numérique.

C'est à l'utilisateur d'apprécier la solution optimale, le coût global dépendant à la fois du besoin en coeur numérique et du coût des composants utilisés ainsi que leur nombre.

Après itérations successives, le calculateur peut être jugé optimisé.

### 7- SEGMENTATION

La segmentation est un processus logiciel automatisé permettant après choix d'une architecture faisceau dans laquelle on introduit un système composé d'un ou plusieurs calculateurs ou modules d'obtenir une liste de toutes les liaisons nécessaires à la prise en compte de l'ensemble du schema tenant compte de l'architecture faisceau choisie (segmentation des liaisons passant par les connexions des éléments entre les faisceaux).

## Revendications

1. Outil informatique pour l'étude d'architectures électriques comportant :
- des moyens de mémorisation dans lesquels sont stockés des fichiers de données primaires décrivant des éléments électriques ou électroniques,
- des moyens pour mettre à jour ces données primaires,
- des moyens pour permettre à un opérateur de créer à partir de ces données primaires des fonctions définies chacune notamment par une liste d'éléments du type de ceux décrits dans les fichiers de données primaires, ainsi que par la description de toutes les liaisons entre ces divers éléments,
- des moyens de mémorisation dans lesquels sont stockées les fonctions ainsi créées,
**caractérisé en ce que**, pour l'étude de l'architecture électrique d'un véhicule automobile, les données primaires décrivent des éléments électriques ou électroniques parmi lesquels des organes de commande et des capteurs de véhicules automobiles, des entrées et sorties électroniques de calculateur, des entrées et sorties de puissance de calculateur, des schémas électroniques de type couches basses associees à ces entrées et sorties électroniques du calculateur, des composants de puissance, des composants électroniques,
et **en ce qu'**il comporte des moyens pour permettre à un opérateur de sélectionner plusieurs ensembles de fichiers et pour de façon automatique :
- générer pour chaque ensemble de fonctions choisi, une liste dite consolidée des éléments correspondant à ces différentes fonctions, dans laquelle les redondances entre éléments sont supprimées,
- définir pour chacune de ces listes consolidées un calculateur apte à gérer les différentes fonctions de celles-ci et générer une liste de liaisons dite consolidée décrivant les liaisons nécessaires pour la mise en oeuvre des différentes fonctions choisies, dans laquelle les redondances entre liaisons sont supprimées,
- regrouper ces calculateurs en les associant à des architectures de faisceaux de liaison mémorisés, afin de définir des systèmes,
- calculer les coûts des calculateurs ainsi regroupés et/ou de leurs fonctions, afin de permettre à l'opérateur de sélectionner un système correspondant pour lui à une solution optimale.

2. Outil selon l'une des revendications précédentes, **caractérisé en ce qu'**il comporte des moyens de mémorisation dans lesquels sont stockées les schémas des architectures de faisceaux de différents types de véhicule.

3. Outil selon la revendication 2, **caractérisé en ce qu'**il comporte des moyens pour proposer une segmentation optimisée à partir d'une architecture de faisceau donnée et d'un fichier de modules ou calculateurs consolidés.

4. Outil selon l'une des revendications précédentes, **caractérisé en ce qu'**il comporte des moyens permettant à un opérateur de modifier les schémas électriques appelés couches basses associées à un module de calculateur pour optimiser ledit module.

5. Outil selon l'une des revendications précédentes, **caractérisé en ce qu'**il comporte des moyens mémoire dans lesquels sont stockées des spécifications et/ou des schémas et/ou des nomenclatures associés aux éléments décrits dans les fichiers de données primaires.

6. Outil selon l'une des revendications précédentes, **caractérisé en ce qu'**il comporte des moyens de mémorisation dans lesquels sont stockées des spécifications et/ou des schémas et/ou des fiches signalétiques associés aux fonctions.

7. Outil selon la revendication 6, **caractérisé en ce qu'**il comporte des moyens pour regrouper les informations contenues dans des fiches signalétiques associées à des fonctions dans un fichier associé au module de calculateur regroupant ces fonctions.

8. Outil selon l'une des revendications précédentes, **caractérisé en ce qu'**il comporte des moyens pour mémoriser et/ou traiter de façon différenciée les fonctions selon qu'elles sont destinées à être intégrées à des architectures conventionnelles, destinées à être consolidées à un seul module de calculateur ou destinées à être consolidées en plusieurs modules.

## Patentansprüche

1. Computerwerkzeug zur Untersuchung von elektrischen Installationsarchitekturen, das folgendes umfaßt:
- Speichermittel, in denen Dateien mit Primärdaten zur Beschreibung von elektrischen oder elektronischen Elementen gespeichert sind,
- Mittel zur Aktualisierung dieser Primärdaten,
- Mittel, um einem Bediener die Möglichkeit zu geben, auf der Grundlage dieser Primärdaten Funktionen zu erstellen, die jeweils insbesondere durch eine Liste von Elementen in der Art der in den Primärdaten-Dateien beschriebenen Elemente sowie durch die Beschreibung aller Verbindungen zwischen diesen verschiedenen Elementen definiert sind,
- Speichermittel, in denen die so erstellen Funktionen gespeichert sind,
**dadurch gekennzeichnet, daß** zur Untersuchung der elektrischen Installationsarchitektur eines Kraftfahrzeugs die Primärdaten elektrische oder elektronische Elemente beschreiben, darunter Betätigungsorgane und Sensoren von Kraftfahrzeugen, elektronische Rechner-Eingänge und Ausgänge, Rechner-Leistungseingänge und -ausgänge, elektronische Schaltbilder in Low Layer-Ausführung im Zusammenhang mit diesen elektronischen Ein- und Ausgängen des Rechners, Leistungskomponenten, Elektronikkomponenten,
und daβ es Mittel umfaßt, um einem Bediener die Möglichkeit zu geben mehrere Dateiengruppen auszuwählen, und um automatisch:
- für jede ausgewählte Funktionengruppe eine sogenannte konsolidierte Liste der Elemente entsprechend diesen verschiedenen Funktionen zu erzeugen, in der die Redundanzen zwischen Elementen unterdrückt sind,
- für jede dieser konsolidierten Listen einen Rechner zu definieren, der in der Lage ist, deren verschiedene Funktionen zu verwalten, und eine sogenannte konsolidierte Verbindungsliste zur Beschreibung der notwendigen Verbindungen für die Ausführung der verschiedenen ausgewählten Funktionen zu erzeugen, in der die Redundanzen zwischen Verbindungen unterdrückt sind,
- diese Rechner zu gruppieren, indem sie Architekturen von gespeicherten Verbindungskabelsträngen zugeordnet werden, um Systeme zu definieren,
- die Kosten der so gruppierten Rechner und/oder ihrer Funktionen zu berechnen, um dem Bediener die Möglichkeit zu geben, ein System auszuwählen, das für ihn einer optimalen Lösung entspricht.

2. Werkzeug nach dem vorangehenden Anspruch, **dadurch gekennzeichnet, daß** es Speichermittel umfaßt, in denen die Schaltbilder der Kabelsatzarchitekturen unterschiedlicher Fahrzeugtypen gespeichert sind.

3. Werkzeug nach Anspruch 2, **dadurch gekennzeichnet, daß** es Mittel umfaßt, um eine optimierte Segmentierung auf der Grundlage einer gegebenen Kabelsatzarchitektur und einer Datei mit konsolidierten Modulen oder Rechnern vorzuschlagen.

4. Werkzeug nach einem der vorangehenden Ansprüche, **dadurch gekennzeichnet, daß** es Mittel umfaßt, die einem Bediener die Möglichkeit geben, die einem Rechnermodul zugeordneten, als Low Layer bezeichneten elektrischen Schaltbilder zu verändern, um das besagte Modul zu optimieren.

5. Werkzeug nach einem der vorangehenden Ansprüche, **dadurch gekennzeichnet, daß** es Speichermittel umfaßt, in denen Spezifikationen und/oder Schaltbilder und/oder Stücklisten gespeichert sind, die den in den Primärdaten-Dateien beschriebenen Elementen zugeordnet sind.

6. Werkzeug nach einem der vorangehenden Ansprüche, **dadurch gekennzeichnet, daß** es Speichermittel umfaßt, in denen den Funktionen zugeordnete Spezifikationen und/oder Schaltbilder und/oder Kenndatenblätter gespeichert sind.

7. Werkzeug nach Anspruch 6, **dadurch gekennzeichnet, daß** es Mittel zur Gruppierung der Informationen umfaßt, die in Kenndatenblättern enthalten sind, die Funktionen in einer Datei zugeordnet sind, die dem diese Funktionen umfassenden Rechnermodul zugeordnet ist.

8. Werkzeug nach einem der vorangehenden Ansprüche, **dadurch gekennzeichnet, daß** es Mittel umfaßt, um die Funktionen unterschiedlich zu speichern und/oder zu verarbeiten, je nachdem ob sie dazu bestimmt sind, in konventionelle Architekturen integriert zu werden, ob sie dazu bestimmt sind, in einem einzigen Rechnermodul konsolidiert zu werden, oder ob sie dazu bestimmt sind, in mehreren Modulen konsolidiert zu werden.

## Claims

1. A computer tool for designing electrical architectures, including:
- memory means in which are stored primary data files describing electrical or electronic components,
- means for updating said primary data,
- means enabling an operator to create from said primary data functions each of which is defined in particular by a list of components of the type described in the primary data files and by a description of all the connections between said components, and
- memory means in which the functions created in this way are stored,
**characterized in that**, to design the electrical architecture of an automobile vehicle, the primary data describes electrical or electronic components including control units, sensors, computer electronic inputs and outputs, computer power inputs and outputs, low layer electronic schematics associated with said computer electronic inputs and outputs, power components, electronic components,
and **in that** it includes means for allowing an operator to select several sets of files and for automatically:
- generating, for each chosen set of functions, a consolidated list of components corresponding to said functions, in which redundancies between components are eliminated,
- defining, for each of these consolidated lists, a computer able to manage their functions, and generating a consolidated list of connections describing the links necessary for implementing the chosen functions, in which the redundancies between links are eliminated,
- grouping these computers together by associating them with stored link wiring harness architectures, so as to define systems,
- computing the costs of the computers thus grouped together and/or of their functions, so as to allow the operator to select a system corresponding therefor to an optimal solution.

2. A tool according to the preceding claim, **characterized in that** it includes memory means in which are stored schematics of wiring harness architectures of different types of vehicle.

3. A tool according to Claim 2, **characterized in that** it includes means for proposing an optimized segmentation based on a given wiring harness architecture and a file of consolidated modules or computers.

4. A tool according to any preceding claim, **characterized in that** it includes means enabling an operator to modify electrical schematics referred to as low layer schematics associated with a computer module in order to optimize said module.

5. A tool according to any preceding claim, **characterized in that** it includes memory means in which are stored specifications and/or schematics and/or parts lists associated with components described in the primary data files.

6. A tool according to any preceding claim, **characterized in that** it includes memory means in which are stored specifications and/or schematics and/or data sheets associated with functions.

7. A tool according to Claim 6, **characterized in that** it includes means for grouping information contained in data sheets associated with functions in a file associated with the computer module combining those functions.

8. A tool according to any preceding claim, **characterized in that** it includes means for memorizing and/or differentiating processing of functions according to whether they are to be integrated into conventional architectures, consolidated into a single computer module or consolidated into several modules.
